# FASCICULE DE BREVET EUROPEEN

(11) **EP 3 637 458 B1**
(45) Date de publication et mention de la délivrance du brevet: **12.05.2021**
(21) Numéro de dépôt: 19201484.3
(22) Date de dépôt: 04.10.2019
(51) Int. Cl.: H01L 21/67, H01L 21/677

(54) **SYSTÈME DE TRANSPORT D'OBJETS SOUS ATMOSPHÈRE CONTRÔLÉE**
TRANSPORTSYSTEM VON OBJEKTEN UNTER KONTROLLIERTER ATMOSPHÄRE
SYSTEM FOR TRANSPORTING OBJECTS IN CONTROLLED ATMOSPHERE

(30) Priorité: 08.10.2018 FR 1859316
(43) Date de publication de la demande: 15.04.2020
(73) Titulaire: Commissariat à l'énergie atomique et aux énergies alternatives, 75015 Paris (FR)
(72) Inventeur: CURE, Yoann, 38054 GRENOBLE Cedex 09 (FR)
(74) Mandataire: Brevalex

(56) Documents cités:
- FR-A1- 3 014 405
- JP-A- S60 261 302
- US-A- 5 641 054
- US-B1- 6 336 775

## Description

### DOMAINE TECHNIQUE ET ÉTAT DE LA TECHNIQUE ANTÉRIEURE

La présente invention se rapporte à un système de transport d'objets sous atmosphère contrôlée, pouvant notamment être mis en œuvre dans le domaine de la microélectronique.

Dans le domaine de la microélectronique, les procédés de fabrication requièrent souvent un contrôle de l'atmosphère dans laquelle se situe l'objet microélectronique, par exemple un substrat ou wafer, en cours de fabrication.

Il existe des circuits sous atmosphère contrôlée, par exemple sous ultravide, permettant le transport de l'objet entre deux enceintes confinées, dans lesquelles des étapes technologiques peuvent avoir lieu. Ainsi le confinement sous atmosphère contrôlée n'est jamais rompu.

Le circuit comporte par exemple des tubes connectés les uns aux autres de manière étanche et auquel sont raccordées des enceintes également de manière étanche. Un ou des chariots se déplacent dans les tubes pour acheminer les objets d'une enceinte à l'autre. Le diamètre intérieur des tubes est suffisant pour la circulation des chariots chargés des substrats.

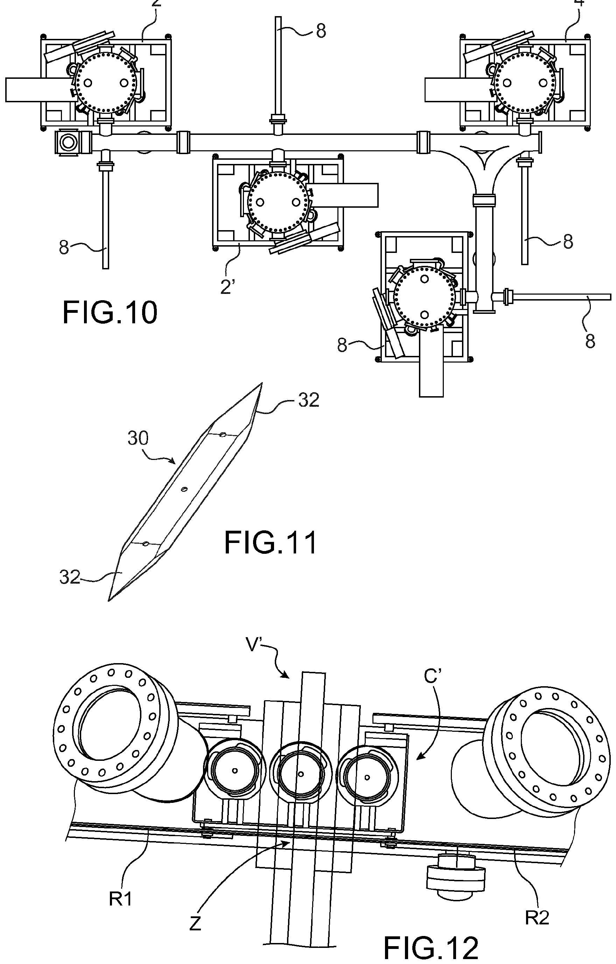

La figure 12 montre un tel circuit. Le circuit est divisé en tronçons étanches les uns par rapport aux autres afin d'isoler les enceintes les unes des autres. L'isolation des tronçons est obtenue par des vannes V', comportant par exemple une porte coulissante transversalement aux tubes. Afin de modifier la communication entre deux tubes, la porte est coulissée. Lorsque la porte est totalement coulissée à l'extérieur du tube, les deux tronçons de part et d'autre de la porte sont en communication et un chariot peut circuler d'un tronçon à l'autre.

Le chariot C' se déplace sur un rail central disposé dans le fond du tube. Le chariot comporte des roulement ou galets coopérant entre les bords du rail.

Au passage de la vanne V', le rail est interrompu à l'endroit où la porte coulisse en position fermée. Sur la figure 12, on peut voir cette zone de passage de vanne Z'. Le chariot C' doit présenter une dimension suffisante dans le sens de déplacement et/ou un nombre de galets suffisants pour assurer un franchissement de la zone sans rail entre les deux tronçons, de sorte que le chariot soit correctement guidé lors du franchissement entre le rail amont R1 et le rail aval R2 et éviter un porte-à-faux trop important, qui désalignerait le chariot C' par rapport au rail aval R et pourrait à termes détériorer le chariot et/ou le système de transport.

Il existe d'autres systèmes plus complexes et plus coûteux, dans lesquels les objets sont déplacés par des bras pour les faire passer des tronçons à l'autre lorsque la vanne est ouverte. D'une part cette manipulation requiert un bras très précis afin de ne pas casser l'objet lorsqu'il est saisi ou relâché. D'autre part, il requiert des objets très bien calibrés pour qu'ils soient correctement saisis. Ces bras sont de conception complexe et le coût de revient est élevé, en outre ils nécessitent un réglage régulier

Le document US 6 336 775 B1 décrit un système de transport d'objets sous atmosphère contrôlée.

### EXPOSÉ DE L'INVENTION

C'est par conséquent un but de la présente invention d'offrir un système de transport sous atmosphère contrôlée de réalisation relativement simple et robuste.

Le but énoncé ci-dessus est atteint par un système de transport par chariot sous atmosphère contrôlée comportant au moins deux tronçons tubulaires connectables et séparées par une vanne, chaque tronçon tubulaire comportant au moins une voie de déplacement d'un chariot. La vanne comporte une porte apte à coulisser transversalement par rapport à la direction de déplacement du chariot et séparant les deux voies de déplacement. Le système comporte également des moyens permettant au chariot de franchir la zone où coulisse la porte pour passer d'une enceinte à l'autre, lesdits moyens comportant un élément apte à passer d'une position relevée vers une position abaissée dans laquelle il forme un prolongement des voies de déplacement. Ainsi le chariot n'a pas besoin de présenter une grande longueur pour assurer le franchissement de cette zone « vide », mais il se déplace sur cet élément quelle que soit sa longueur. Les moyens de franchissement sont disposés d'un côté et/ou de l'autre de la zone et s'escamotent, par exemple lorsque la porte de la vanne est remise en place et sépare de nouveau les tronçons tubulaires.

De manière très avantageuse, le passage d'une position à l'autre est obtenu directement par le déplacement de la porte, par exemple lors de la fermeture de la porte, celle-ci repousse l'élément de franchissement vers sa position relevée qui bascule.

En d'autres termes, le système de transport met en œuvre un organe apte à combler une distance entre deux chemins de guidage. De manière très avantageuse, le système est de type pont-levis pour franchir les zones de vanne et qui prolonge les chemins amont et aval sur lesquels se déplace le chariot.

Dans un exemple de réalisation, l'élément de franchissement comporte à proximité du passage de vanne, une surface de franchissement et des moyens d'articulations de ladite surface, apte à passer d'une première position dans laquelle la surface est dans la prolongation de la voie de déplacement, la vanne étant ouverte, à une deuxième position, dans laquelle la surface est en position relevée pour permettre la fermeture de la vanne.

De manière particulièrement avantageuse, les voies de déplacement comportent des bords latéraux en regard parallèles à la direction de déplacement et avec lesquels les galets des chariots coopèrent. Le rail central peut alors être supprimé, ce qui permet de réduire sensiblement les coûts de fabrication et la complexité de réalisation. En effet, l'utilisation de rails centraux impose un alignement très précis entre le rail d'un tronçon et le rail du tronçon directement suivant. Or cet alignement très précis est complexe et long à réaliser, notamment lors d'opération d'étuvage des tubes, par exemple pour l'obtention d'ultravide. Cette opération d'étuvage entraîne un désalignement des rails, qui impose un démontage du système et une rectification des rails. Grâce à l'exemple très avantageux selon l'invention, une telle étape de rectification peut être supprimée.

De manière très avantageuse, dans un exemple de réalisation le contrôle de la position de l'élément de franchissement est entièrement mécanique et automatique, celui-ci étant en appui contre la porte lorsqu'elle isole les deux enceintes et s'abaisse en suivant la porte lorsque la porte coulisse pour mettre en communication les deux enceintes.

La présente invention a alors pour objet un système de transport d'objets sous atmosphère contrôlée comportant au moins deux tronçons, chacun comportant une première extrémité et une deuxième extrémité, lesdits tronçons, étant connectés entre eux de manière étanche par leurs extrémités, chaque tronçon, comportant au moins un chemin de guidage pour un chariot, chaque chemin de guidage comportant une première et une deuxième extrémités au niveau des première et deuxième extrémités des tronçons respectivement, les extrémités de chemins de guidage étant en regard et distantes l'une de l'autre d'une distance donnée D. Le système de transport comporte également des moyens franchissement de ladite distance D comprenant au moins un élément de franchissement situé à proximité de l'un au moins des chemins de guidage en regard, apte à se déplacer entre une première position dite de repos dans laquelle l'élément de franchissement libère l'espace entre les chemins de guidage et une deuxième position dite de franchissement dans laquelle l'élément de franchissement prolonge les chemins de guidage.

Dans un mode de réalisation avantageux, le au moins un élément de franchissement est articulé en rotation sur une extrémité de l'un au moins des chemins de guidage en regard, autour d'un axe orthogonale à une direction de déplacement dudit chemin de guidage, ledit élément de franchissement étant mobile entre la position de franchissement et la position de repos

Par exemple, les extrémités des tronçons sont connectées de manière étanche par une vanne, ladite vanne comportant une porte disposée entre les extrémités en regard des chemins de guidage, ladite porte étant mobile avantageusement transversalement par rapport à la direction de déplacement des chemins de guidage.

De manière avantageuse, le passage d'une position à une autre de l'élément de franchissement est commandé par le déplacement de la porte. Par exemple, la porte comporte une extrémité supérieure disposée sous ou au-dessus de l'élément de franchissement en position ouverte de sorte à permettre l'articulation dudit élément.

En position de repos, l'élément de franchissement peut être en appui contre la porte, de sorte que lorsque la porte se déplace vers la position ouverte, l'élément de franchissement pivote par gravité vers la position de franchissement.

La porte est avantageusement sous l'élément de franchissement de sorte que la mise en place de l'élément de franchissement en position de franchissement se fasse par gravité.

En variante, la porte se situe au-dessus de l'élément de franchissement en position ouverte, un système de rappel tel qu'un ressort peut alors être associé à l'élément de franchissement.

Dans un exemple de réalisation, l'élément de franchissement et la porte comportent chacun un aimant, les aimants étant disposés et orientés de sorte que, lorsque la porte se déplace vers la position de repos, les aimants se repoussent provoquant le pivotement de l'élément de franchissement vers une position de repos.

Le système peut comporter au moins une vanne étanche disposée entre deux tronçons tubulaires et comportant une partie mobile permettant d'isoler ou de connecter les tronçons tubulaires, l'élément de franchissement étant situé sur la partie mobile de la vanne.

De préférence, l'élément de franchissement comporte une surface de franchissement formée par une plaque.

Le système de transport peut comporter au moins un chariot comprenant au moins une paire de galets, les galets étant disposés entre le chariot et le chemin de guidage pour permettre le déplacement du chariot selon la direction de déplacement et assurer son alignement par rapport au chemin de guidage.

Les chemins de guidage comportent avantageusement chacun deux bords latéraux en regard, au moins un galet de chaque paire coopérant avec un bord latéral de sorte à assurer un guidage du chariot le long de la direction de déplacement.

Dans un exemple de réalisation, le système de transport comporte au moins un tronçon tubulaire courbe de sorte à former un circuit de déplacement en deux dimensions.

Le système de transport peut comporter plusieurs tronçons tubulaires courbes et au moins un tronçon tubulaire droit agencés les uns par rapport aux autres pour former une zone de retournement et/ou de réserve d'au moins un chariot.

La présente invention a également pour objet un système de manipulation d'objets comportant au moins un système de transport selon l'invention, et au moins une chambre disposée le long d'un tronçon tubulaire et connectée à celui-ci avantageusement de manière étanche, et des moyens pour transférer les objets entre le chariot et ladite chambre.

Le système de manipulation d'objets peut avantageusement comporter des moyens de positionnement dudit chariot dans une position donnée par rapport à la chambre et aux moyens de transfert. Les moyens de positionnement comportent par exemple au moins une portion de rail disposée dans la direction du déplacement du tronçon tubulaire et entre la chambre et les moyens de transfert. Le chariot comporte des galets configurés pour coopérer avec la portion de rail.

La portion e rail peut être situé sur le chemin de guidage ou au-dessus de celui-ci sur la paroi du tronçon ; cette portion de rail est en outre avantageusement située au centre du chemin de guidage.

Par exemple les objets sont des substrats portés par des porte-substrats. L'atmosphère contrôlée dans le système est l'ultravide, et la au moins une chambre est une chambre de dépôt.

### BRÈVE DESCRIPTION DES DESSINS

La présente invention sera mieux comprise sur la base de la description qui va suivre et des dessins en annexe sur lesquels:
- la figure 1 est une vue de dessus d'un exemple d'un système de transport sous atmosphère contrôlée selon l'invention,
- la figure 2 est une vue en perspective d'un exemple de vanne d'un système de transport selon un exemple de la présente invention,
- la figure 3 est une vue en perspective d'un exemple de chariot utilisable dans le système de transport selon l'invention,
- les figures 4A et 4B sont des vues en perspective de variantes de réalisation d'éléments de franchissement,
- les figures 5A et 5B sont des vues en perspective d'un élément de franchissement dans une position relevée et dans une position de franchissement respectivement,
- les figures 5C et 5D sont des vues en perspective d'un chemin de guidage et de l'élément de franchissement respectivement,
- les figures 6A à 6C sont des vues en perspective des différentes configurations d'un exemple du système de transport selon l'invention au niveau du passage d'une vanne entre une vanne en position fermée et une vanne en position ouverte,
- La figure 7 est une vue de dessus d'un autre exemple de système de transport selon l'invention,
- La figure 8 est une représentation schématique du système de la figure 7 dans lequel se déplace un chariot,
- La figure 9 est une représentation schématique d'un exemple d'un système de transport selon l'invention permettant un déplacement hors-plan du chariot,
- la figure 10 est une vue de dessus d'une variante de réalisation du système de transport de la figure 7,
- la figure 11 est une vue en perspective d'un exemple de moyens de positionnement du chariot, représentés seuls,
- la figure 12 est une vue de côté d'un système de transport de l'état de la technique au niveau d'un passage de vanne.

### EXPOSÉ DÉTAILLÉ DE MODES DE RÉALISATION PARTICULIERS

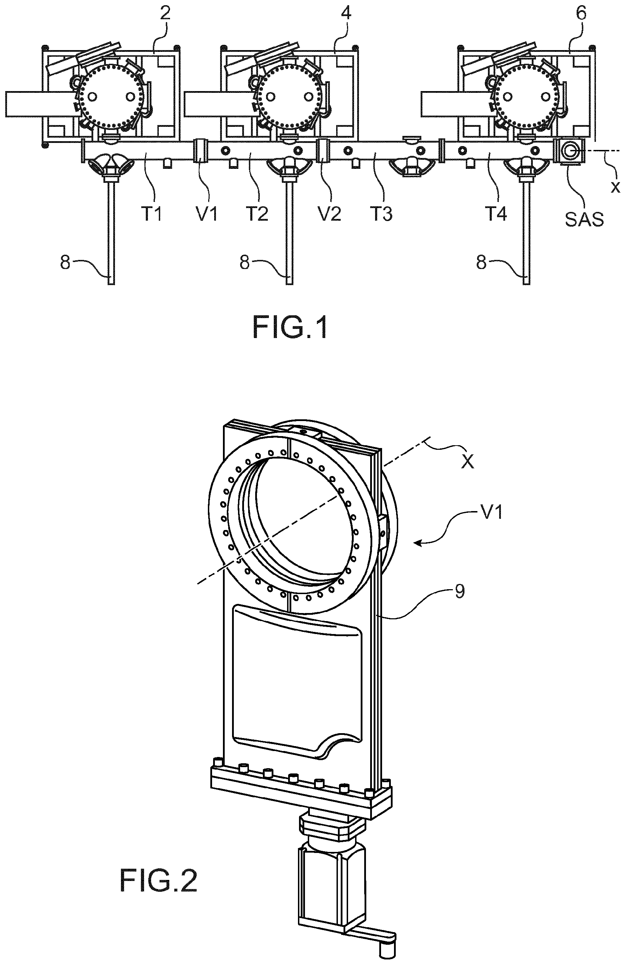

Sur la figure 1, on peut voir une vue de dessus d'un exemple d'un système de transport sous atmosphère contrôlée selon l'invention.

La présente invention va être décrite dans le cadre du transport de porte-substrats, par exemple du transport de porte-substrats en molybdène, appelés molyblocs, entre différentes chambres dans lesquelles les substrats transportés subissent des traitements, par exemple de dépôts en ultravide. L'invention peut s'appliquer au transport de tout autre objet, par exemple au transport d'une charge de matériau par exemple dans certains systèmes à ultravide ou au transport d'objets type capsule pour transporter des personnes qui sont dans une atmosphère différente de l'atmosphère contrôlée, par exemple à pression atmosphérique. La capsule est alors fermée de sorte à l'isoler de l'atmosphère contrôlée régnant à l'intérieur du système de transport, et peut être équipée de sièges pour les personnes.

Le système de transport comporte une succession de tubes T1, T2 ; T3 ; T4 à section circulaire connectés entre eux de manière étanche et délimitant un volume intérieur isolé de l'extérieur. Les tubes sont alignés le long de la direction X.

Dans la présente demande, on entend par « tube », « tronçon» ou « tronçon tubulaire », des éléments allongés creux de section circulaire, elliptique, ovoïde, polygonale, par exemple carrée ou rectangulaire, elliptique ...débouchant à leurs deux extrémités, ces tubes peuvent être droits et/ou présenter une ou plusieurs courbures. Le système comporte un sas de communication avec l'extérieur SAS connecté à l'extrémité du tube T4.

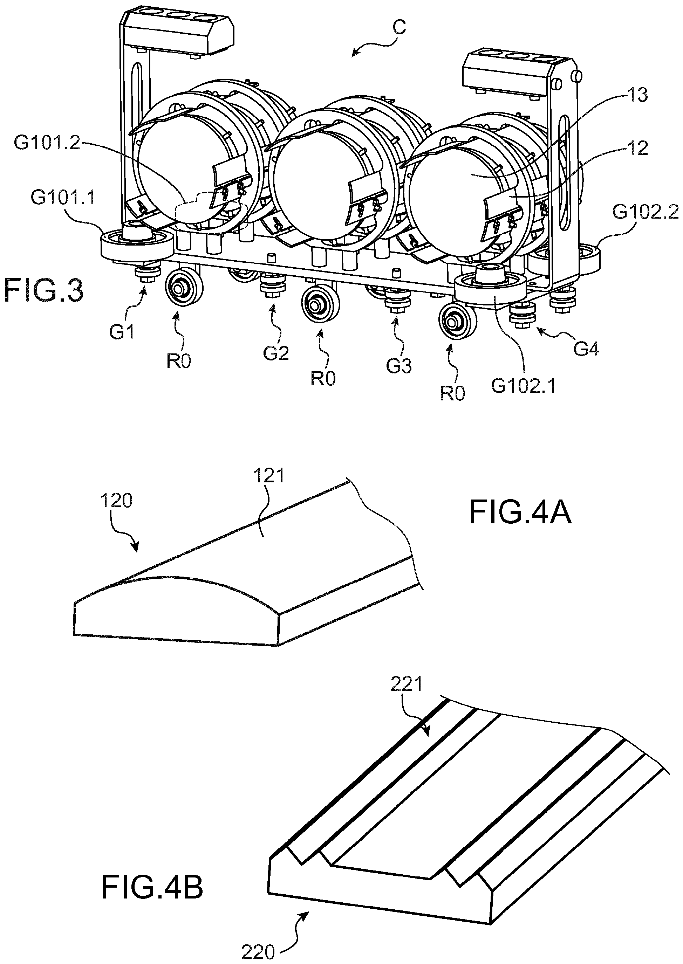

Le système de transport permet le déplacement d'un chariot C (figure 3) entre différentes chambres 2, 4, 6, qui sont disposées latéralement par rapport à la succession de tubes et connectées de manière étanche au volume intérieur. Chaque chambre peut être isolée du volume intérieur par une vanne (non représentée).

Le système comporte également des cannes de transfert 8 destinées à assurer le transfert des porte-substrats entre le chariot C et une chambre 2, 4, 6. Les cannes sont montées mobiles en translation dans une direction transversale par rapport à la direction X. Les cannes 8 comportent à une extrémité longitudinale (non visible) située dans le système des moyens de préhension des porte-substrats, par exemple des griffes. Les cannes sont manipulées par leur autre extrémité longitudinale.

Le volume intérieur est divisé de manière étanche par des vannes V1, V2 assurant notamment une séparation étanche entre des portions du volume intérieur connectées chacune à une chambre.

Sur la figure 2, on peut voir une vue de détail d'un exemple de vanne V1 en position ouverte. La vanne V1 comporte une porte 9 montée coulissante transversalement par rapport à la direction X. Pour ouvrir la vanne la porte coulisse vers le bas. En variante, la porte pourrait pivoter autour d'un axe parallèle à l'axe X. La porte peut être orthogonale à l'axe X ou incliné par rapport à l'axe X.

Un exemple de chariot est représenté sur la figure 3. Il comporte un châssis 10 muni des roulettes RO destinées à rouler sur le chemin de guidage. Il comporte également des paires de premiers galets ou roulements G1, G2, G3, G4 répartis le long de la direction le long de laquelle le chariot est destiné à se déplacer et d'axe vertical. Les premiers galets sont destinés à coopérer avec une portion de rail de centrage 30 qui sera décrit ci-dessous.

Il comporte également des paires de deuxièmes galets ou roulements G101.1, G101.2, G102.1, G102.2, deux dans l'exemple représenté et situé aux deux extrémités longitudinales du chariot et destinés d'un part à réaligner le chariot par rapport au chemin de guidage et d'autre part à aider le chariot à tourner dans un virage.

On entend par « galet » ou « roulement » tout élément permettant le déplacement et/ou le guidage du chariot et notamment une roue, une bille, un rouleau.

Le chariot comporte des logements 12 pour des porte-substrats 13. Le chariot est destiné à glisser ou à rouler dans le système de transport.

Le système de transport comporte également des moyens pour guider le chariot C le long de la direction de déplacement. Pour cela, les fonds inférieurs des tubes comportent des chemins de guidage 14, 15 avec lesquels les galets vont coopérer. En variante, plusieurs chemins de guidage peuvent être superposés ou juxtaposés dans les tronçons.

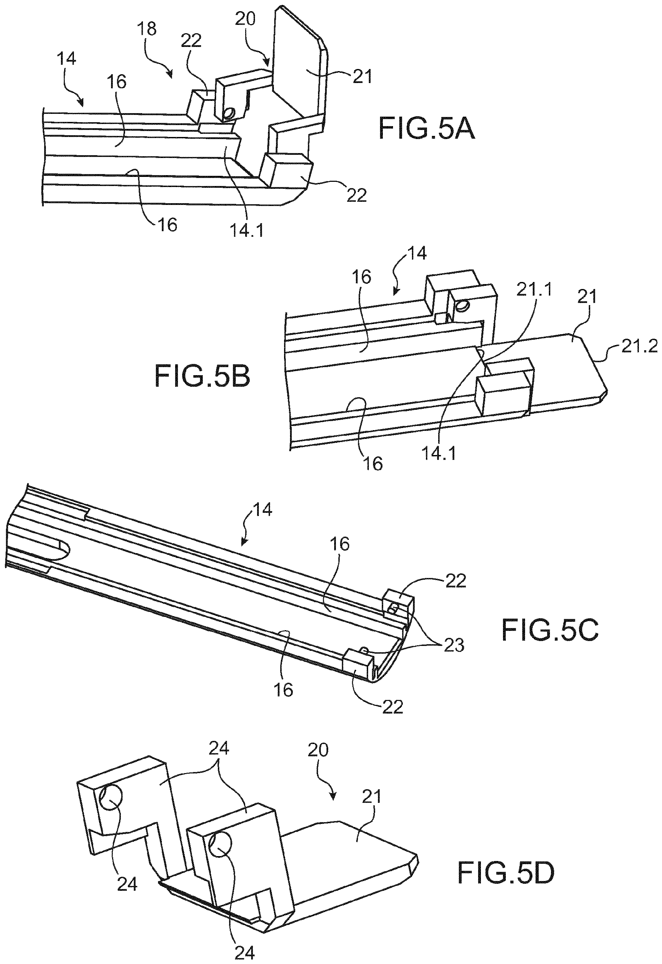

Sur les figures 5A et 5B, on peut voir un exemple particulièrement avantageux chaque chemin de guidage comportant des bords latéraux extérieurs 16 délimitant transversalement la largeur du chemin de guidage et formant deux bandes de roulement pour les galets. Ainsi les galets G101.1, G101.2, G102.1, G102.2 d'une paire coopèrent chacun avec un bord latéral extérieur 16. Les galets sont alors guidés par l'extérieur. Un jeu est prévu entre les galets et les bords latéraux 16, par exemple de 1 mm à 2 mm. Le contact entre les galets et les bords latéraux 16 n'est en général pas continu. La coopération entre les galets les bords latéraux permet de réaligner le chariot avec l'axe X, lorsque le chariot s'écarte trop de l'axe X. En variante, le chariot ne comporte pas de roues Ro et comporte un surface de glissement destinée à glisser sur les chemins de guidage.

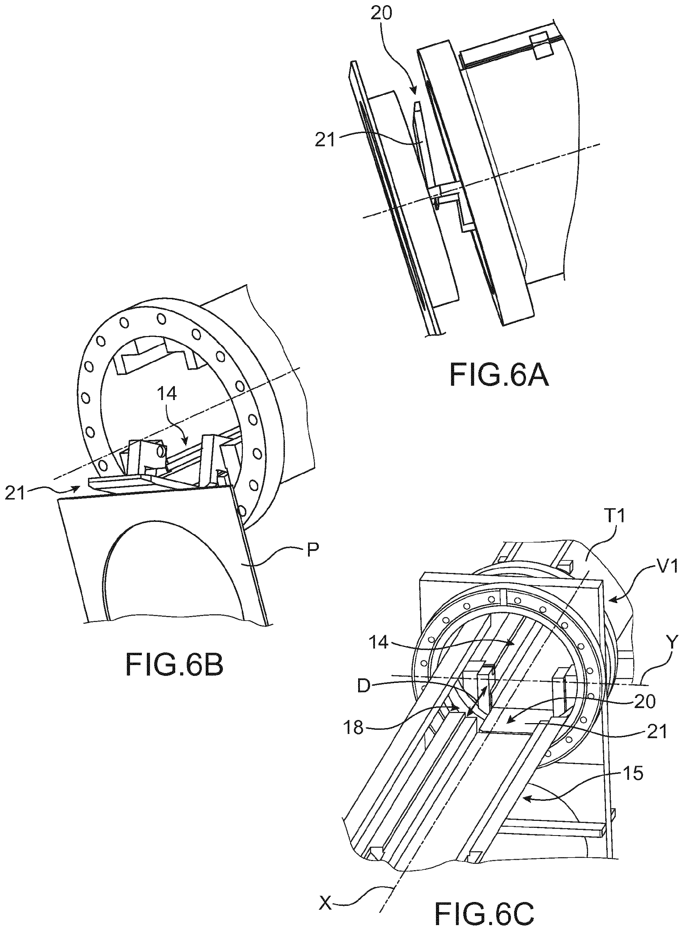

Les chemins de guidage sont interrompus au niveau des vannes, dites zones de vanne, afin de permettre la fermeture des vannes et la mise en place des portes. Les extrémités libres en regard de deux chemins de guidage successifs au niveau d'une vanner sont séparées par une distance D (figure 6C).

Le système de transport comporte également des moyens 18 de franchissement des zones de vanne. Les moyens de franchissement 18 sont tels que, lorsque la vanne est ouverte le chariot peut passer d'un chemin de guidage à un autre à travers les vannes.

Les moyens de franchissement 18 comportent au moins un élément 20 apte à combler au moins partiellement la zone de vanne entre les deux chemins de guidage lorsque la vanne est ouverte et à s'occulter lors de la fermeture de la vanne.

Pour simplifier la description, on désignera un chemin de guidage amont et un chemin de guidage aval de part et d'autre de la zone de vanne, mais les termes « amont » et « aval » ne sont pas limitatifs en ce qui concerne le déplacement du chariot, puisque le chariot peut circuler dans les deux sens et donc de l'aval vers l'amont.

En outre, on qualifie de « proximales » les extrémités des chemins de guidage situées du côté de la zone de vanne.

Dans l'exemple représenté, l'élément 20 est articulé en rotation sur une extrémité proximale 14.1 du chemin de guidage amont 14, autour d'un axe Y orthogonal à l'axe X. L'élément 20 comporte une surface de franchissement 21 formée par une plaque comblant la zone de vanne et empêchant le chariot de basculer dans la zone de vanne. Le guidage est assuré par les galets G101.1, G101.2, G102.1, G102.2 coopérant encore avec les bords latéraux du chemin amont et/ou par les galets coopérant déjà avec les bords latéraux du chemin aval. Dans cet exemple le chariot roule sur la surface de franchissement 21.

La dimension de l'élément de franchissement 20, considérée selon la direction de déplacement, est inférieure ou égale à la distance D, la différence entre ladite distance D et la longueur dudit élément de franchissement 20 étant inférieure à la longueur du chariot.

Dans cet exemple la surface de franchissement est plane. En variante l'élément de franchissement 120 a une surface de franchissement 121 bombée (figure 4A) ou l'élément de franchissement 220 a une surface de franchissement 221 comportant une structure en dents de scie (figure 4B) formant deux rails latéraux. Ces rails peuvent éventuellement servir de guidage pour les roues du chariot. D'autres formes de surface de franchissement sont envisageables.

Dans l'exemple représenté, l'élément de franchissement est articulé en rotation au moyen de deux pions 22 portés par deux pattes 23 solidaires du chemin de roulement amont (figure 5D). Les pions 22 sont en saillie vers l'intérieur du chemin de roulement sans gêner le passage du chariot. En variante, les pions 22 font saillie latéralement à l'extérieur du chemin de roulement, les pattes 24 sont alors disposées à l'extérieur des pattes 23.

Il sera compris qu'un ou plus de deux pions peuvent être envisagés pour assurer l'articulation de l'élément de franchissement sur l'extrémité du chemin de guidage.

L'élément de franchissement comporte deux pattes 24 munies chacune d'un perçage 26 recevant chacun un pion (figure 5C). Les pattes 24 sont disposées entre les pattes 23.

Inversement les pions peuvent être portés par l'élément 20 et les perçages par le chemin de guidage 14.

Une autre articulation pivot de type charnière peut être envisagée.

Dans cet exemple, lorsque l'élément de franchissement 20 est en position de franchissement, l'extrémité longitudinale 21.1 de la surface de franchissement orientée du côté du chemin de guidage amont 14, sur lequel elle est articulée, vient en butée contre l'extrémité proximale libre 14.1 de celui-ci, formant d'une part avec celui-ci une surface de déplacement continue, et assurant d'autre part le maintien de l'élément de franchissement dans la position de franchissement. L'autre extrémité longitudinale 21.2 de la surface de franchissement se trouve en regard de l'extrémité proximale libre du chemin de guidage aval à une distance réduite de celle-ci, par exemple à une distance permettant le pivotement de l'élément de franchissement sans contact.

En variante, l'extrémité longitudinale 21.1 peut ne pas venir en butée contre l'extrémité proximale libre du chemin aval, dans le cas où le maintien de l'élément de franchissement est assuré par ailleurs. Par exemple on peut envisager que l'extrémité libre 21.2 vienne en appui sur l'extrémité proximale libre du chemin aval, assurant alors le maintien. Il peut être envisagé de ménager un évidement dans l'extrémité proximale libre du chemin aval pour loger l'extrémité 21.2 de la surface de franchissement.

Dans un autre exemple, l'élément 20 comporte, comme les chemins de guidage, des bords latéraux de guidage séparés l'un de l'autre d'une distance sensiblement égale à celle séparant les bords de guidage des chemins de guidage, de sorte que lorsque l'élément de franchissement est en place, des bords latéraux sensiblement continus soient formés avec lesquels les galets peuvent coopérer. Le guidage du chariot est alors assuré par l'élément de franchissement lui-même, il ne forme pas uniquement une surface de glissement. Dans ce cas le chariot peut être de longueur réduite et les galets plus proches les uns des autres, puisque le guidage n'est pas assuré uniquement par les bords des chemins amont et aval de part et d'autre de la zone de vanne.

Sur la figure 5A, on peut voir l'élément de franchissement en position relevée et la figure 5B en position de franchissement, lors que la porte est ouverte.

Sur les figures 6A à 6C, on peut voir la coopération entre l'élément de franchissement et la porte de la vanne.

Sur la figure 6A, la porte P est fermée et l'élément de franchissement 20 est en appui contre la porte. Sur la figure 6B, la porte P est en cours d'ouverture, elle coulisse vers le bas, l'élément de franchissement 21 est en appui sur la porte et suit son déplacement sous l'effet de la gravité, il pivote vers la position alignée avec les chemins de guidage. Sur la figure 6C, la porte P est complètement ouverte, l'élément de franchissement 20 est aligné avec les chemins de guidages amont 14 et aval 15, un chemin de guidage entre les chemins de guidage amont et aval est formé.

Lors de la fermeture de la porte P, elle entre en contact avec l'élément de franchissement 20 par le dessous et le repousse, celui-ci pivote en sens inverse et reprend sa position relevée.

L'élément de franchissement est disposé au-dessus de l'extrémité supérieure de la porte en position ouverte. Ainsi, lors de la fermeture, la porte pousse effectivement l'élément de franchissement soit par contact mécanique, soit par répulsion magnétique.

Le fonctionnement du système est très robuste, car il ne met pas en œuvre de moyens électromécaniques. En outre le système utilise avantageusement le déplacement de la porte de la vanne qui était déjà en place dans les systèmes existants.

Selon une variante de réalisation, les moyens de franchissement comportent deux éléments de franchissement, l'un articulé en rotation sur l'extrémité proximale du rail amont et l'autre articulé en rotation sur l'extrémité proximale du rail aval ; du type pont levant à deux tabliers. Ainsi chaque élément de franchissement pivote en sens inverse de l'autre, autour de son axe de rotation, et leurs extrémités libres se trouvent en regard l'une de l'autre lorsqu'ils sont en position de franchissement.

En variante encore, les moyens de franchissement comportent un élément de franchissement maintenu en position relevée par un ressort ou une lame ressort par exemple disposée sous l'élément de franchissement. Le basculement de l'élément de franchissement en position de franchissement est alors obtenu sous l'action du poids du chariot qui accoste l'élément de franchissement.

Dans un exemple de réalisation, le déplacement de l'élément de franchissement est commandé par des moyens magnétiques. Par exemple, le ou les éléments de franchissement comportent un aimant permanent et la porte comporte également un aimant permanent. Les pôles des aimants sont orientés de sorte qu'une force de répulsion apparaisse entre la porte et le ou les éléments de franchissement, lorsque la porte se relève. La commande de déplacement de l'élément de franchissement se fait alors sans contact mécanique entre la porte et le ou les éléments de franchissement.

Dans l'exemple décrit les chemins de guidage et l'élément de franchissement forment une route, le chariot étant guidé uniquement par les bords latéraux.

Dans un autre exemple, les chemins de guidage comportent un rail central et l'élément de franchissement comporte un rail central qui, lorsque l'élément de franchissement est en position de franchissement est aligné avec les rails des chemins amont et aval. Les galets G1, G2, G3, G4 coopèrent avec les rails centraux. En variante, l'élément de franchissement ne comporte pas de rail et est formé par une portion de route. Cet exemple demande néanmoins une réalisation plus complexe au niveau de l'alignement des rails,

Dans l'exemple des figures 5A à 6C, on peut envisager de remplacer l'élément de franchissement par un élément de franchissement muni d'un rail central.

Le déplacement du chariot dans le système peut être réalisé par l'extérieur au moyen d'aimants qui sont déplacés le long du système de transport et exercent une attraction sur le chariot qui est en matériau apte à être attiré par un ou plusieurs aimants. Le chariot peut lui-même porter des aimants. Sur la figure 3, le chariot comporte des aimants sur sa partie supérieure au-dessus des logements des substrats. Les aimants extérieurs sont par exemple guidés le long des tronçons à l'extérieur de ceux-ci et au-dessus de ceux-ci de sorte à pouvoir être à l'aplomb des aimants portés par le chariot, les aimants sont par exemple guidés par des rails.

Dans un autre exemple rendu possible par la mise en œuvre des éléments de franchissement, les moyens de déplacement comportent deux pistes électriques le long des chemins de guidage et des éléments de franchissement et un moteur électrique porté par le chariot et alimenté via les pistes électriques. Les pistes conductrices sont reliées à une source électrique situé à l'extérieur du système, par l'intermédiaire de traversés électriques étanches.

La mise en œuvre des éléments de franchissement permet de maintenir l'alimentation du moteur pendant la traversée d'une zone de vanne

La mise en œuvre de chemins de guidage dans lesquels le chariot est guidé par des bords latéraux extérieurs, présente un certain nombre d'avantages. D'une part, la réalisation d'un système de transport avec de tels chemins est plus simple que dans le cas d'un système mettant en œuvre des rails, puisqu'elle ne nécessite pas les différentes étapes d'alignement et de réalignement des rails.

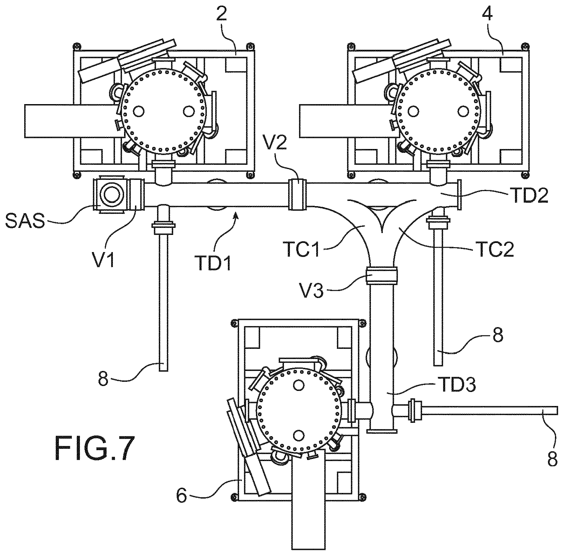

En outre, le guidage par les bords latéraux permet de réaliser des systèmes de transport avec des virages tels que représentés sur la figure 7, alors que la mise en œuvre de rails empêche de réaliser des virages au risque de bloquer le chariot.

Les deuxièmes galets des paires G101, G102 à axe verticaux assurent le guidage du chariot dans des virages. En effet, par exemple lorsque le chariot attaque un virage tournant vers la droite, par exemple entraîné par un aimant extérieur, les roulements latéraux de droite (G101.1, G102.1 dans la représentation de la figure 3) entrent en contact avec le bord latéral 16, ce qui assure une rotation progressive du chariot.

La réalisation des chemins de guidage courbes offre des nombreuses possibilités en termes de manipulation des chariots et d'orientation des chambres le long du système de transport.

Le système de transport de la figure 7 comporte un premier tronçon droit TD1, prolongé par un deuxième tronçon droit TD2 et séparé du premier tronçon droit TD1 par une vanne V2. Le système de transport comporte une première portion courbe TC1 se raccordant par une première extrémité au premier tronçon droit TD1 au niveau de la vanne V2 en parallèle du deuxième tronçon droit TD2. Le système comporte également un deuxième tronçon courbe TC2 s'étendant entre la deuxième extrémité du premier tronçon courbe TC2 et l'extrémité du deuxième tronçon droit TD2 non reliée au premier tronçon droit TD1. Un troisième tronçon droit TD3 est connecté aux premier et deuxième tronçons courbes TC1 et TC2 par l'intermédiaire d'une vanne V3. Le circuit du système de transport a sensiblement la forme d'un T.

Le système de transport comporte également un sas de communication avec l'extérieur SAS connecté à l'extrémité libre du premier tronçon droit TD1 et permettant de charger/décharger le chariot. Une vanne V1 est interposée entre le sas et le premier tronçon droit TD1.

Le système de transport comporte au niveau du passage des vannes des éléments de franchissement tels que décrits ci-dessus.

Le système de transport assure le déplacement de chariots entre plusieurs chambres 2, 4, 6.

La réalisation d'un tel circuit est permise par la mise en œuvre de chemin de guidage sans rail.

Nous allons maintenant donner des exemples de déplacement permis par un tel circuit.

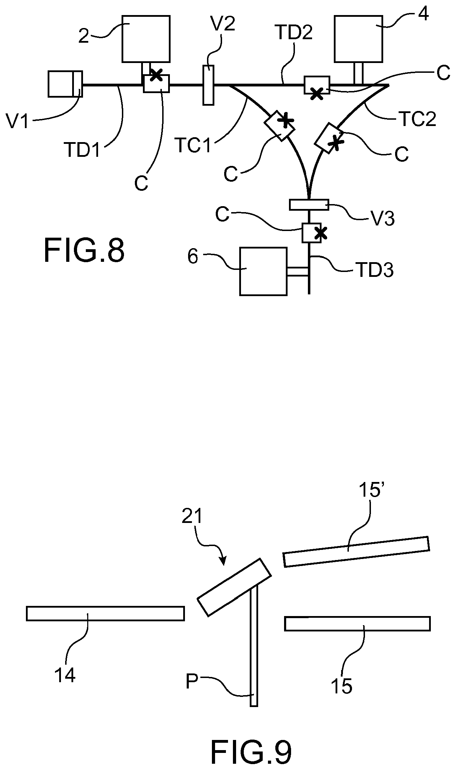

Ce circuit permet de retourner un chariot. Le déplacement du chariot est schématisé sur la figure 8 par le rectangle. Une face du chariot est repérée par une croix.

En effet, le chariot entre dans le système par le sas. Il circule dans le premier tronçon droit TD1, puis dans le premier tronçon courbe TC1 en circulant sur un élément de franchissement à travers la vanne V2, puis dans le troisième tronçon droit TD3 en circulant sur un élément de franchissement à travers la vanne V3. Ensuite, le chariot C est déplacé dans le sens opposé sur le troisième tronçon droit TD3, traverse la vanne V3 en circulant sur l'élément de franchissement et circule sur le deuxième tronçon courbe TC2. Arrivé à l'autre extrémité du deuxième tronçon courbe TC2, le chariot circule sur le deuxième tronçon droit TD2 en direction du premier tronçon droit TD1. On constate que la face du chariot repérée par une croix a changé de côté par rapport à la direction de déplacement sur les premier et deuxième tronçons droits TD1 et TD2, le chariot a effectivement été retourné. Un tel retournement n'est pas réalisable avec un système de transport à rail de l'état de la technique.

Ce circuit permet également d'utiliser plusieurs chariots dans le même système de transport et de permettre le croisement de ceux-ci.

En effet, lorsqu'un premier chariot est déjà dans le système de transport, il est possible d'introduire un deuxième chariot et de disposer le chariot en regard de l'une quelconque des chambres. En effet, le premier chariot peut être stocké provisoirement, par exemple dans le premier ou le deuxième tronçon courbe TC1 et TC2, pour laisser le passage libre au deuxième chariot. Ainsi il est possible de créer une réserve ou une voie de garage pour un ou plusieurs chariots. En outre, le premier chariot peut être extrait du système avant le deuxième chariot. Ceci n'est pas réalisable avec un système de transport muni de rails, dans un tel système le chariot introduit ultérieurement ne peut croiser le chariot introduit antérieurement, et il doit être retiré avant d'introduire l'autre chariot.

Un système de transport tel que celui de la figure 7 peut par exemple permettre d'augmenter le rendement de traitement des substrats.

En outre, la mise en œuvre combinée de chemins de guidage sans rail et d'élément de franchissement peut permettre de faire passer un chariot entre deux chemins de guidage décalés verticalement. Par exemple, en ouvrant la vanne à moitié de sa course, on peut faire monter un chariot sur un chemin aval d'étage supérieur. En ouvrant la vanne entièrement, l'élément de franchissement vient prolonger la route dans le même plan

En effet l'élément de franchissement peut présenter plusieurs orientations angulaires par rapport au chemin de guidage sur lequel il est articulé.

Sur la figure 9, on peut voir une représentation schématique d'un exemple d'un tel circuit. Le degré d'ouverture de la porte P règle l'angle de basculement de l'élément de franchissement et oriente l'extrémité libre de l'élément de franchissement vers l'un au l'autre des chemins de guidage aval 15, 15' superposés. Il sera compris que l'angle d'inclinaison de l'élément de franchissement par rapport au chemin auquel il est articulé est suffisamment grand pour permettre au chariot de circuler du chemin de guidage sur l'élément de franchissement sans coincement et en sécurité. La longueur de l'élément de franchissement est de préférence choisie pour faciliter la circulation du chariot.

Avantageusement les chemins de guidage aval peuvent être inclinés en direction de la vanne pour faciliter le passage du chariot.

De plus les chemins de guidage sans rail peuvent également présenter une certaine courbure dans une direction hors-plan.

Il est alors possible de réaliser des systèmes de transport en trois dimensions.

Par ailleurs, de tels chemins de déplacement offrent une grande liberté dans la disposition des chambres par rapport à la direction de déplacement, ce qui peut permettre un gain de place important pour le circuit. Sur la figure 10 le système de transport est très proche de celui de la figure 7, il comporte une chambre supplémentaire 2' sur le premier tronçon droit TD1 mais située à l'opposé de la chambre 2' par rapport à la direction de déplacement. En effet, puisque le chariot peut être retourné, il peut présenter la même face à la chambre 2 et à la chambre 2', après avoir emprunté la zone de retournement formée par les tronçons TC1, TC2, TD2. Dans un système de transport de l'état de la technique mettant en œuvre des rails, les chambres sont nécessairement toujours du même côté par rapport à la direction de déplacement.

De manière très avantageuse, le système de transport comporte des moyens de positionnement 28 du chariot par rapport aux chambres pour permettre de manipuler des éléments sur le chariot au moyen d'une canne. L'inventeur a déterminé que le positionnement précis du chariot n'était pas requis tout le long du déplacement du ou des chariots, et que le positionnement précis était suffisant lorsqu'un transfert entre le chariot et une chambre était requis.

Par exemple, les moyens de positionnement 28 comportent une portion de rail 30 représentée seule sur la figure 11, fixée sur le chemin de guidage au droit d'une chambre. Lorsque le chariot arrive au niveau d'une chambre, les galets G1, G2, G3, G4 coopèrent naturellement avec la portion de rail 30, et assurent automatiquement le centrage et le positionnement du chariot par rapport à la chambre.

Afin de faciliter le positionnement des galets par rapport à la portion de rail, celle-ci comporte des extrémités longitudinales 32 biseautées.

En variante, le positionnement précis d'un chariot par rapport à une chambre peut être obtenu par l'intermédiaire des bords extérieurs présentant un usinage plus fin au niveau seulement des chambres.

Dans les exemples décrits, l'élément de franchissement es articulé sur un ou des chemins de guidage. En variante, l'élément de franchissement est solidaire de la porte de la vanne au niveau de son extrémité supérieure, par exemple il s'étend perpendiculairement à la porte, la porte et le chemin de franchissement ayant, vus de côté, une forme en T. lorsque la porte s'abaisse, l'élément de franchissement s'abaisse également et vient s'aligner avec les chemins de guidage amont et aval.

## Revendications

1. Système de transport d'objets sous atmosphère contrôlée comportant au moins deux tronçons (T1, T2, T3, T4), chacun comportant une première extrémité et une deuxième extrémité, lesdits tronçons (T1, T2, T3, T4), étant connectés entre eux de manière étanche par leurs extrémités, chaque tronçon (T1, T2, T3, T4), comportant au moins un chemin de guidage (14, 15) pour un chariot, Le système de tant **caractérisé en ce que** chaque chemin de guidage (14, 15) comporte une première et une deuxième extrémités au niveau des première et deuxième extrémités des tronçons respectivement, les extrémités de chemins de guidage (14, 15) étant en regard et distantes l'une de l'autre d'une distance donnée D, et dans quel le système de transport comporte également des moyens de franchissement (18) de ladite distance D comprenant au moins un élément de franchissement (20) situé à proximité de l'un au moins des chemins de guidage (14, 15) en regard, apte à se déplacer entre une première position, dite de repos, dans laquelle l'élément de franchissement (20) l'espace entre les chemins de guidage et une deuxième position, dite de franchissement, dans laquelle l'élément de franchissement prolonge les chemins de guidage.

2. Système de transport selon la revendication 1, dans lequel ledit au moins un élément de franchissement est articulé en rotation sur une extrémité de l'un au moins des chemins de guidage (14, 15) en regard, autour d'un axe orthogonal à une direction de déplacement dudit chemin de guidage (14, 15), ledit élément de franchissement (20) étant mobile entre la position de franchissement et la position de repos.

3. Système de transport selon la revendication 1 ou 2, dans lequel les extrémités des tronçons (T1, T2, T3, T4) sont connectées de manière étanche par une vanne (V1, V2, V3), ladite vanne (V1, V2, V3), comportant une porte (P) disposée entre les extrémités en regard des chemins de guidage (14, 15), ladite porte (P) étant mobile avantageusement transversalement par rapport à la direction de déplacement des chemins de guidage (14, 15).

4. Système de transport selon la revendication 3, dans lequel le passage d'une position à une autre de l'élément de franchissement (20) est commandé par le déplacement de la porte (P), la porte (P) comportant avantageusement une extrémité supérieure disposée sous ou au-dessus de l'élément de franchissement (20) en position ouverte de sorte à permettre l'articulation dudit élément.

5. Système de transport selon la revendication 4 dans lequel, en position de repos, l'élément de franchissement (20) est en appui contre la porte (P), de sorte que lorsque la porte (P) se déplace vers la position ouverte, l'élément de franchissement (20) pivote par gravité vers la position de franchissement.

6. Système de transport selon la revendication 4, dans lequel l'élément de franchissement (20) et la porte (P) comportent chacun un aimant, les aimants étant disposés et orientés de sorte que, lorsque la porte se déplace vers la position de repos, les aimants se repoussent provoquant le pivotement de l'élément de franchissement (20) vers une position de repos.

7. Système de transport selon la revendication 1, comportant au moins une vanne étanche disposée entre deux tronçons et comportant une partie mobile permettant d'isoler ou de connecter les tronçons, l'élément de franchissement étant situé sur la partie mobile de la vanne.

8. Système de transport selon l'une des revendications précédentes, dans lequel l'élément de franchissement (20) comporte une surface de franchissement formée par une plaque (21).

9. Système de transport selon l'une des revendications précédentes, comportant au moins un chariot (C) comprenant au moins une paire de galets (G101.1, G101.2, G102.1, G102.2), les galets étant disposés entre le chariot et le chemin de guidage pour permettre le déplacement du chariot selon la direction de déplacement et assurer son alignement par rapport au chemin de guidage.

10. Système de transport selon la revendication 9, dans lequel les chemins de guidage (14, 15) comportent chacun deux bords latéraux (16) en regard, au moins un galet de chaque paire coopérant avec un bord latéral (16) de sorte à assurer un guidage du chariot le long de la direction de déplacement.

11. Système de transport selon l'une des revendications 1 à 10, comportant au moins un tronçon courbe (TC1, TC2) de sorte à former un circuit de déplacement en deux dimensions.

12. Système de transport selon l'une des revendications 1 à 11, comportant plusieurs tronçons courbes (TC1, TC2) et au moins un tronçon droit (TD1) agencés les uns par rapport aux autres pour former une zone de retournement et/ou de réserve d'au moins un chariot.

13. Système de manipulation d'objets comportant au moins un système de transport selon l'une des revendications 1 à 12, au moins une chambre (2, 4, 6) disposée le long d'un tronçon et connectée à celui-ci avantageusement de manière étanche, des moyens pour transférer les objets entre le chariot et ladite chambre, le système de manipulation comportant avantageusement des moyens de positionnement (28) dudit chariot dans une position donnée par rapport à la chambre et aux moyens de transfert.

14. Système de manipulation d'objets selon la revendication précédente, dans lequel les moyens de positionnement (30) comportent au moins une portion de rail (30) disposée dans la direction du déplacement dans le tronçon et entre la chambre et les moyens de transfert, et dans lequel le chariot comporte des galets configurés pour coopérer avec ladite portion de rail.

15. Système de manipulation d'objets selon la revendication 13 ou 14, dans lequel les objets sont des substrats portés par des porte-substrats, dans lequel l'atmosphère contrôlée est l'ultravide, et dans lequel la au moins une chambre est une chambre de dépôt.

## Patentansprüche

1. System zum Transport von Objekten unter kontrollierter Atmosphäre, umfassend wenigstens zwei Abschnitte (T1, T2, T3, T4), von denen jeder ein erstes Ende und ein zweites Ende umfasst, wobei die Abschnitte (T1, T2, T3, T4) miteinander an ihren Enden auf dichte Weise verbunden sind, wobei jeder Abschnitt (T1, T2, T3, T4) wenigstens einen Führungsweg (14, 15) für einen Wagen umfasst, wobei das Transportsystem **dadurch gekennzeichnet ist, dass** jeder Führungsweg (14, 15) ein erstes und ein zweites Ende im Bereich des ersten beziehungsweise des zweiten Endes der Abschnitte umfasst, wobei die Enden von Führungswegen (14, 15) einander gegenüber liegen und voneinander um einen gegebenen Abstand D beabstandet sind, und wobei das Transportsystem ferner Mittel (18) zur Überquerung des Abstands D umfasst, die wenigstens ein Überquerungselement (20) umfassen, das in der Nähe wenigstens eines der gegenüberliegenden Führungswege (14, 15) angeordnet ist, das dazu ausgelegt ist, sich zu verlagern zwischen einer ersten Position, genannt Ruheposition, in der das Überquerungselement (20) den Raum zwischen den Führungswegen freigibt, und einer zweiten Position, genannt Überquerungsposition, in der das Überquerungselement die Führungswege verlängert.

2. Transportsystem nach Anspruch 1, bei dem das wenigstens eine Überquerungselement an einem Ende des wenigstens einen der gegenüberliegenden Führungswege (14, 15) drehbar um eine Achse angelenkt ist, die orthogonal ist zu einer Verlagerungsrichtung des Führungswegs (14, 15), wobei das Überquerungselement (20) zwischen der Überquerungsposition und der Ruheposition beweglich ist.

3. Transportsystem nach Anspruch 1 oder 2, bei dem die Enden der Abschnitte (T1, T2, T3, T4) auf dichte Weise mittels eines Ventils (V1, V2, V3) verbunden sind, wobei das Ventil (V1, V2, V3) eine Tür (P) umfasst, die zwischen den gegenüberliegenden Enden der Führungswege (14, 15) angeordnet ist, wobei die Tür (P) vorzugsweise transversal bezogen auf die Verlagerungsrichtung der Führungswege (14, 15) beweglich ist.

4. Transportsystem nach Anspruch 3, bei dem der Übergang des Überquerungselements (20) von einer Position zu einer anderen durch die Verlagerung der Tür (P) gesteuert wird, wobei die Tür (P) vorzugsweise ein oberes Ende umfasst, das unter oder über dem Überquerungselement (20) in der offenen Position angeordnet ist, derart, dass die Anlenkung des Elements ermöglicht wird.

5. Transportsystem nach Anspruch 4, bei dem das Überquerungselement (20) in der Ruheposition in Anlage gegen die Tür (P) derart ist, dass dann, wenn sich die Tür (P) in Richtung der offenen Position verlagert, das Überquerungselement (20) durch Schwerkraft in Richtung der Überquerungsposition schwenkt.

6. Transportsystem nach Anspruch 4, bei dem das Überquerungselement (20) und die Tür (P) jeweils einen Magnet umfassen, wobei die Magnete derart angeordnet und orientiert sind, dass dann, wenn sich die Tür in Richtung der Ruheposition verlagert, die Magnete sich abstoßen, was die Schwenkung des Überquerungselements (20) in Richtung einer Ruheposition auslöst.

7. Transportsystem nach Anspruch 1, umfassend wenigstens ein dichtes Ventil, das zwischen zwei Abschnitten angeordnet ist und einen beweglichen Teil umfasst, der es ermöglicht, die Abschnitte zu isolieren oder zu verbinden, wobei das Überquerungselement an dem beweglichen Teil des Ventils angeordnet ist.

8. Transportsystem nach einem der vorhergehenden Ansprüche, bei dem das Überquerungselement (20) eine Überquerungsoberfläche umfasst, die durch eine Platte (21) gebildet ist.

9. Transportsystem nach einem der vorhergehenden Ansprüche, umfassend wenigstens einen Wagen (C), der wenigstens ein Paar von Rollen (G101.1, G101.2, G102.1, G102.2) umfasst, wobei die Rollen zwischen dem Wagen und dem Führungsweg angeordnet sind, um die Verlagerung des Wagens entlang der Verlagerungsrichtung zu ermöglichen und seine Ausrichtung mit Bezug zu dem Führungsweg zu gewährleisten.

10. Transportsystem nach Anspruch 9, bei dem die Führungswege (14, 15) jeweils zwei gegenüberliegende laterale Ränder (16) umfassen, wobei wenigstens eine Rolle von jedem Paar mit einem lateralen Rand (16) derart zusammenwirkt, dass eine Führung des Wagens entlang der Verlagerungsrichtung gewährleistet wird.

11. Transportsystem nach einem der Ansprüche 1 bis 10, umfassend wenigstens einen gebogenen Abschnitt (TC1, TC2) derart, dass ein Kreis zur Verlagerung in zwei Dimensionen gebildet wird.

12. Transportsystem nach einem der Ansprüche 1 bis 11, umfassend mehrere gebogene Abschnitte (TC1, TC2) und wenigstens einen geraden Abschnitt (TD1), die relativ zueinander derart angeordnet sind, dass eine Zone zur Umkehr und/oder zur Reserve wenigstens eines Wagens gebildet wird.

13. System zur Handhabung von Objekten, umfassend wenigstens ein Transportsystem nach einem der Ansprüche 1 bis 12, wenigstens eine Kammer (2, 4, 6), die entlang eines Abschnitts angeordnet und mit ihm vorzugsweise auf dichte Weise verbunden ist, Mittel zum Transferieren der Objekte zwischen dem Wagen und der Kammer, wobei das Handhabungssystem vorzugsweise Mittel (28) zur Positionierung des Wagens in einer gegebenen Position mit Bezug zu der Kammer und zu den Transfermitteln umfasst.

14. System zur Handhabung von Objekten nach dem vorhergehenden Anspruch, bei dem die Positionierungsmittel (30) wenigstens einen Schienenbereich (30) umfassen, der in der Verlagerungsrichtung in dem Abschnitt und zwischen der Kammer und den Transfermitteln angeordnet ist, und wobei der Wagen Rollen umfasst, die dazu konfiguriert sind, mit dem Schienenbereich zusammenzuwirken.

15. System zur Handhabung von Objekten nach Anspruch 13 oder 14, bei dem die Objekte Substrate sind, die durch Substratträger getragen werden, bei dem die kontrollierte Atmosphäre Ultrahochvakuum ist, und bei dem die wenigstens eine Kammer eine Abscheidungskammer ist.

## Claims

1. System for transporting objects under controlled atmosphere comprising at least two sections (T1, T2, T3, T4), each section comprising a first end and a second end, said at least two sections (T1, T2, T3, T4) being connected together in a leak tight manner by their ends, each section (T1, T2, T3, T4) comprising at least one guide track (14, 15) for a trolley, the transport system being **characterized in that** each guide track (14, 15) comprises a first and a second end at the level of the first and second ends of the sections respectively, the ends of the guide tracks (14, 15) facing each other and separated from each other by a given distance D, and **in that** the transport system also comprises means for spanning said distance D including at least one spanning element (20) situated near to one at least of the opposite guide tracks (14, 15), configured to be displaced between a first so-called rest position, in which the spanning element (20) frees the space between the guide tracks and a second so-called spanning position, in which the spanning element extends the guide tracks.

2. Transport system according to claim 1, in which said at least one spanning element is rotationally hinged on an end of one at least of the opposite guide tracks (14, 15), around an axis orthogonal to a direction of displacement of said guide track (14, 15), said spanning element (20) being moveable between the spanning position and the rest position.

3. Transport system according to claim 1 or 2, in which the ends of the sections (T1, T2, T3, T4) are connected in a leak tight manner by a gate (V1, V2, V3, V4), said gate (V1, V2, V3, V4) comprising a door (P) arranged between the ends of the guide tracks (14, 15) which face each other, said door (P) being moveable transversally with respect to the direction of displacement of the guide tracks (14, 15).

4. Transport system according to claim 3, in which the passage from one position to another of the spanning element (20) is controlled by the displacement of the door (P), the door (P) advantageously comprising an upper end arranged under or above the spanning element (20) in open position so as to enable the hinging of said element.

5. Transport system according to claim 4 in which, in rest position, the spanning element (20) bears against the door (P), such that when the door (P) is displaced to the open position, the spanning element (20) pivots by gravity to the spanning position.

6. Transport system according to claim 4, in which the spanning element (20) and the door (P) each comprise a magnet, the magnets being arranged and oriented such that, when the door is displaced to the rest position, the magnets repel each other causing the pivoting of the spanning element (20) to a rest position.

7. Transport system according to claim 1, comprising at least one leak tight gate arranged between two sections and comprising a moveable part making it possible to isolate or to connect the sections, the spanning element being situated on the moveable part of the gate.

8. Transport system according to one of the preceding claims, in which the spanning element (20) comprises a spanning surface formed by a plate (21).

9. Transport system according to one of the preceding claims, comprising at least one trolley (C) including at least one pair of rollers (G101.1, G101.2, G102.1, G102.2), the rollers being arranged between the trolley and the guide track to enable the displacement of the trolley along the direction of displacement and to ensure its alignment with respect to the guide track.

10. Transport system according to claim 9, in which the guide tracks (14, 15) each comprise two opposite side edges (16), at least one roller of each pair cooperating with a side edge (16) so as to ensure a guiding of the trolley along the direction of displacement.

11. Transport system according to one of the claims 1 to 10, comprising at least one curved section (TC1, TC2) so as to form a two dimensional displacement circuit.

12. Transport system according to one of the claims 1 to 11, comprising several curved sections (TC1, TC2) and at least one straight section (TD1) laid out with respect to each other to form a turnaround and/or reserve zone for at least one trolley.

13. System for handling objects comprising at least one transport system according to one of the claims 1 to 12, and at least one chamber (2, 4, 6) arranged along a section and connected thereto, advantageously in leak tight manner, and means for transferring the objects between the trolley and said chamber, the handling system advantageously comprising means (28) for positioning said trolley in a given position with respect to the chamber and the transfer means.

14. System for handling objects according to the previous claim, in which the means for positioning (30) comprise at least one rail portion (30) arranged in the direction of displacement in the section and between the chamber and the transfer means, and in which the trolley comprises rollers configured to cooperate with said rail portion.

15. System for handling objects according to claim 13 or 14 in which the objects are substrates borne by substrate holders, in which the controlled atmosphere is an ultra-high vacuum, and in which the at least one chamber is a deposition chamber.
